Europäisches Patentamt

(19) European Patent Office

Office européen des brevets

(11) Numéro de publication : **0 218 546 B1**

(12) **FASCICULE DE BREVET EUROPEEN**

(45) Date de publication du fascicule du brevet :
08.05.91 Bulletin 91/19

(51) Int. Cl.⁵ : **G03B 41/00**, G03F 9/00

(21) Numéro de dépôt : **86810382.1**

(22) Date de dépôt : **27.08.86**

(54) **Dispositif de micropositionnement.**

(30) Priorité : 30.08.85 FR 8512944

(43) Date de publication de la demande :
15.04.87 Bulletin 87/16

(45) Mention de la délivrance du brevet :
08.05.91 Bulletin 91/19

(84) Etats contractants désignés :
AT BE CH DE GB IT LI LU NL SE

(56) Documents cités :
EP-A- 0 017 144
EP-A- 0 134 268
EP-A- 0 149 017
FR-A- 2 220 807
P.H.Sydenham, "Elastic design of fine mechanism in instruments", Jpournal of Physics E: Sci. Instrum., Vol. 17 (1984), pp. 922-930

(56) Documents cités :
R.D. Young, "Moving stage improves accuracy of microcircuit measuring technique", Research and Divelopment, April 1984, pp. 114-116

(73) Titulaire : CENTRE SUISSE D'ELECTRONIQUE ET DE MICROTECHNIQUE S.A.
Maladière 71
CH-2000 Neuchâtel 7 (CH)

(72) Inventeur : Schwab, Philippe
rue des Moulins 56b
CH-1400 Yverdon (CH)
Inventeur : Genequand, Pierre M.
rue de Moillebeau 25
CH-1209 Geneve (CH)

(74) Mandataire : Brulliard, Joel
c/o Centre Suisse d'Electronique et de Microelectronique S.A. Maladière 71
CH-2000 Neuchâtel 7 (CH)

## Description

La présente invention se rapporte aux dispositifs de micropositionnement en général et concerne plus particulièrement les dispositifs de micropositionnement destinés à aligner des composants optiques.

Les dispositifs de translation classiques à un degré de liberté se composent d'une plate-forme mobile coulissant sur un châssis de base. L'amplitude du mouvement déterminé par ce guidage coulissant, dit cinématique, est contrôlée par un actionneur, dont le corps est fixé au châssis de base et la partie mobile est reliée à la plate-forme par une transmission appropriée. Lorsque le mouvement de l'actionneur est sensiblement rectiligne et parallèle à l'axe de translation du guidage, la transmission se réduit souvent à un simple appui de la plate-forme contre l'actionneur, par l'intermédiaire d'une bille. L'appui est assuré par un ressort tendu entre le châssis et la plate-forme.

Les actionneurs les plus connus sont de deux types : à vis micrométrique, ou à empilement de pastilles piézoélectriques.

Pour obtenir une translation à deux degrés de liberté, on fixe, sur la plate-forme mobile d'un premier dispositif à un degré de liberté, le châssis d'un deuxième dispositif semblable, mais orienté selon une direction distincte, par example à angle droit. Un example d'un tel dispositif est décrit dans EP-A-0 017 144. La figure 1 représente un translateur classique du commerce, à deux degrés de liberté. D'une façon similaire, en fixant trois modules monodimensionnels en série, on obtiendrait un dispositif à trois degrés de liberté.

Les dispositifs classiques à guidage cinématique permettent de maintenir une bonne précision, typiquement comprise entre un et dix microns, sur des mouvements d'amplitude relativement importante, de l'ordre de dix à cent millimètres. Les grandes courses sont contrôlées par des actionneurs à vis. On monte parfois en série avec la vis, entre l'appui à bille et la plate-forme mobile, un actionneur piézoélectrique. Cet arrangement permet théoriquement d'obtenir une très haute sensibilité, correspondant à une résolution inférieure au centième de micron. Toutefois de telles performances sont illusoires si elles ne sont pas accompagnées d'une stabilité et d'une reproductibilité correspondantes de la part du guidage. Les principales limites des systèmes cinématiques sont données par la précision d'usinage des coulisses, le jeu, le frottement, l'usure.

D'une façon générale, ces dispositifs restent mal adaptés à certaines applications requérant une précision typique du dixième de micron, comme par example le positionnement ou l'assemblage de composants d'optique guidée monomode.

Pour les cas où l'amplitude de déplacement reste faible, typiquement inférieure ou égale au millimètre, on a proposé de faire appel aux principes du guidage élastique, tels qu'ils sont exposés, par exemple, dans l'article de P.H. Sydenham, intitulé "Elastic Design of Fine Mechanism in Instruments" et publié dans J. Phys. E : Sci. Instruments, Vol. 17 (1984) p. 922.

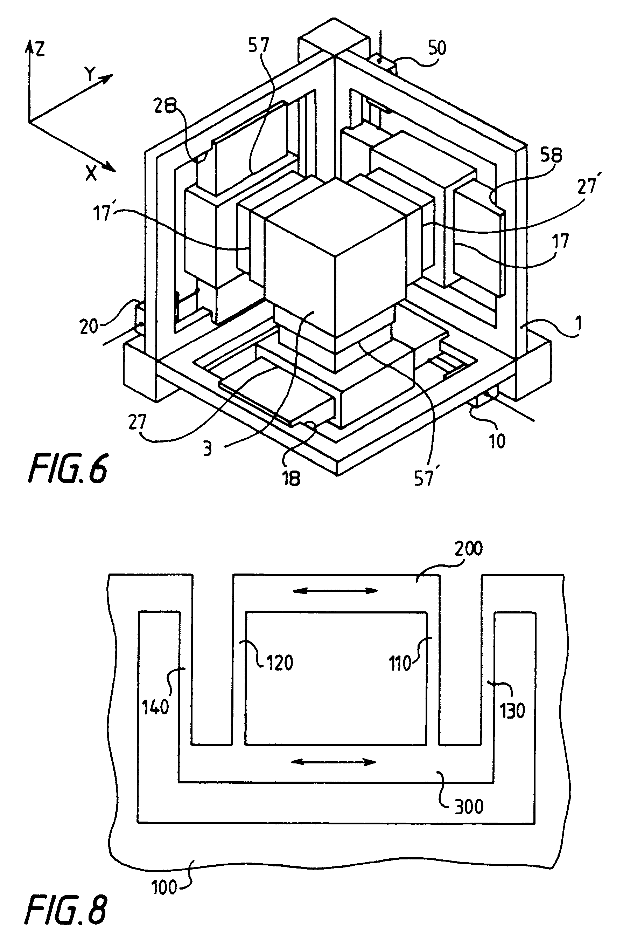

Dans ce type de guidage, on utilise la propriété d'une lame mince et allongée, encastrée à une extrémité et sollicitée à l'autre extrémité, de se prêter aisément à un mouvement de flexion dans la direction perpendiculaire à la lame, tout en restant rigide dans les directions parallèles. Cette flexion de la lame équivaut à une rotation de son extrémité libre autour d'un axe situé dans son plan, lorsqu'elle est au repos. Par une combinaison adéquate de quatre tels "pivots" élastiques, on peut également obtenir une translation, selon le schéma de la figure 7. Cette configuration en parallélogramme peut encore être améliorée de manière à rendre la translation rectiligne, au moyen d'un deuxième parallélogramme. Cette dernière structure, représentée à la figure 8, peut être utilisée pour réaliser un guidage de translation à une coordonnée rectiligne.

Lorsque les déformations sont calculées pour rester bien en deçà des limites élastiques, et que les articulations sont taillées dans la masse, pour éviter les effets d'encastrement, on obtient un dispositif sans jeu, sans frottement et sans usure, parfaitement fidèle et reproductible. La précision n'est limitée que par l'effet, combiné à la rigidité finie des lames selon les directions perpendiculaires au déplacement prévu, d'une charge variable appliquée selon ces directions.

On peut réaliser avantageusement un système élastique monolithique par la méthode connue de l'usinage par électro-érosion. Un dispositif monolithique complexe de guidage élastique, piloté par des actionneurs piézoélectriques, est rapporté par R.D. Young dans l'article intitulé "Moving Stage Improves Accuracy of Microcircuit Measuring Technique", et publié dans Research & Development (April 1984) p. 114. Un autre exemple est donné par le demande de brevet EP-A-0 134 268.

La mise en oeuvre de dispositifs de micropositionnement à articulations élastiques se heurte toutefois à divers problèmes liés à l'intégration des actionneurs dans le système. Les actionneurs piézoélectriques, bien qu'ils offrent une résolution extrêmement élevée, présentent un certain nombre d'inconvénients parmi lesquels : l'exigence d'une tension de commande, qui peut atteindre des valeurs supérieures à 1000 volts, leur réponse non linéaire et l'existence d'une hystérèse importante. L'utilisation de tels actionneurs nécessite la présence d'un détecteur de déplacement incorporé dans une boucle d'asservissement qui est associée à chaque actionneur.

Les actionneurs à vis micrométrique offrent l'avantage d'une course importante mais présentent l'inconvénient d'être relativement lourds et encombrants. La mise en série de plusieurs modules de positionnement à un degré de liberté, pour obtenir des déplacements selon plusieurs coordonnées, n'est plus acceptable pour des systèmes à guidage élastique, sensibles aux effets de charge et de vibrations, si l'on veut tirer profit de leurs propriétés et de leur grande précision intrinsèque.

Aussi un objet de la présente invention est un dispositif de micropositionnement qui ne présente pas les limitations des systèmes décrits précédemment.

Un autre objet de l'invention est un dispositif de micropositionnement à plusieurs degrés de liberté permettant l'assemblage de composants d'optique guidée monomode.

Un autre objet de l'invention est un dispositif de micropositionnement utilisant des moyens de guidage de type élastique.

Un autre objet de l'invention est un dispositif de micropositionnement de structure compacte et peu encombrant.

Un autre objet de l'invention est un dispositif de micropositionnement réalisable par électro-érosion.

D'autres objets, caractéristiques et avantages de la présente invention apparaîtront plus clairement à la lecture de la description suivante d'exemples de réalisation particuliers ; ladite description étant faite à titre purement illustratif et en relation avec les dessins joints dans lesquels :

    – la figure 1 est un schéma d'un dispositif de positionnement connu à deux degrés de liberté et à guidage coulissant ;

    – la figure 2 est une autre représentation du dispositif de la figure 1, mettant en évidence le montage en série des deux modules de déplacement;

    – la figure 3 est un schéma de dispositif à deux degrés de liberté ;

    – la figure 4 montre un exemple de réalisation du dispositif de la figure 3, utilisant des moyens de guidage coulissants ;

    – la figure 5 est un schéma de dispositif à trois degrés de liberté.

    – la figure 6 montre un exemple de réalisation d'un dispositif à trois degrés de liberté, utilisant des moyens de guidage coulissants ;

    – la figure 7 montre un premier exemple de dispositif de translation à guidage élastique ;

    – la figure 8 montre un deuxième exemple de dispositif de translation à guidage élastique ;

    – la figure 9 montre une réalisation planaire d'un dispositif de translation incorporant un moyen de commande ;

    – la figure 10 montre le dispositif de la figure 9 après déformation ;

    – la figure 11 est une vue en coupe d'un dispositif à deux étages ; et

    – les figures 12.a et 12.b montrent un exemple de réalisation préféré de l'invention dans le cas d'un micropositionneur à deux degrés de liberté.

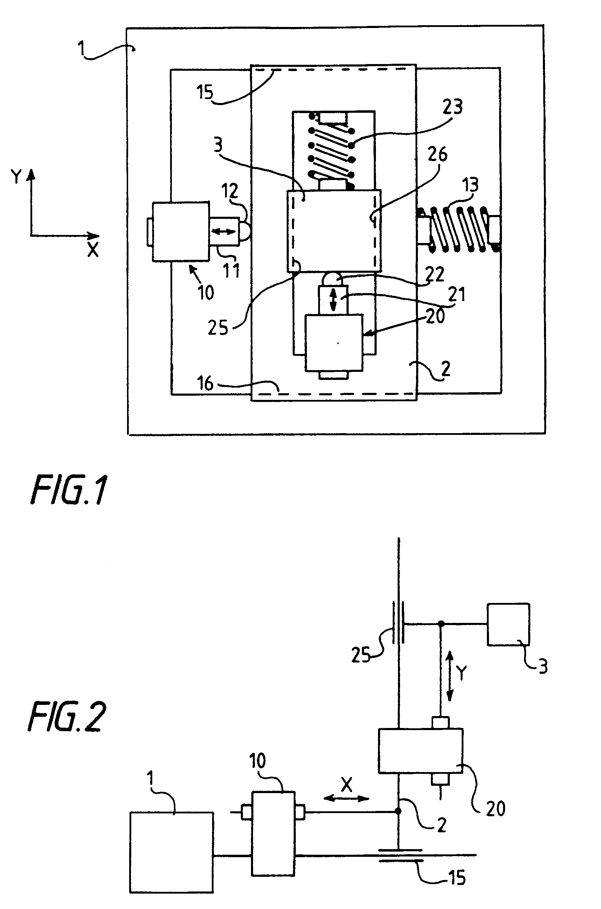

Un schéma connu d'un dispositif de positionnement à deux degrés de liberté est représenté à la figure 1. Il se compose d'un châssis de base 1, sur lequel peut coulisser une plate-forme intermédiaire 2 qui sert de châssis de base pour la plate-forme mobile 3. L'actionneur 10, solidaire du châssis 1, commande, par l'intermédiaire de sa tête mobile 11 et de sa bille d'appui 12, le mouvement de la plate-forme 2 selon une première coordonnée tandis que l'actionneur 20, solidaire de la plate-forme intermédiaire 2, commande, par l'intermédiaire de sa tête mobile 21 et de sa bille d'appui 22, le mouvement de la plate-forme mobile 3 selon une deuxième coordonnée perpendiculaire à la première. L'appui de la plate-forme 2 est assuré par le ressort 13 et celui de la plate-forme mobile 3 est assuré par le ressort 23. Les guidages cinématiques des deux mouvements de translation sont assurés, respectivement, par les zones d'appui 15 et 16 pour la plate-forme 2 et par les zones d'appui 25 et 26 pour la plate-forme mobile 3.

Sur les figures suivantes, les mêmes références se rapportent à des éléments analogues.

Le dispositif de la figure 1 est schématiquement représenté à la figure 2 de manière à rendre plus explicite le montage en série des deux modules de déplacement. Il apparaît ainsi clairement que d'une part, les deux chaînes cinématiques, selon les directions x et y, sont dépendantes l'une de l'autre et d'autre part, si l'actionneur 10 est solidaire de la plate-forme de référence fixe 1, l'actionneur 20 est lui solidaire d'une partie mobile 2. La mise en série des chaînes cinématiques a pour effet premier que les erreurs dues à chaque chaîne s'ajoutent les unes aux autres. De plus, le fait de fixer un actionneur sur une partie mobile constitue un désavantage lorsque des structures compactes et de faibles masses en mouvement sont recherchées.

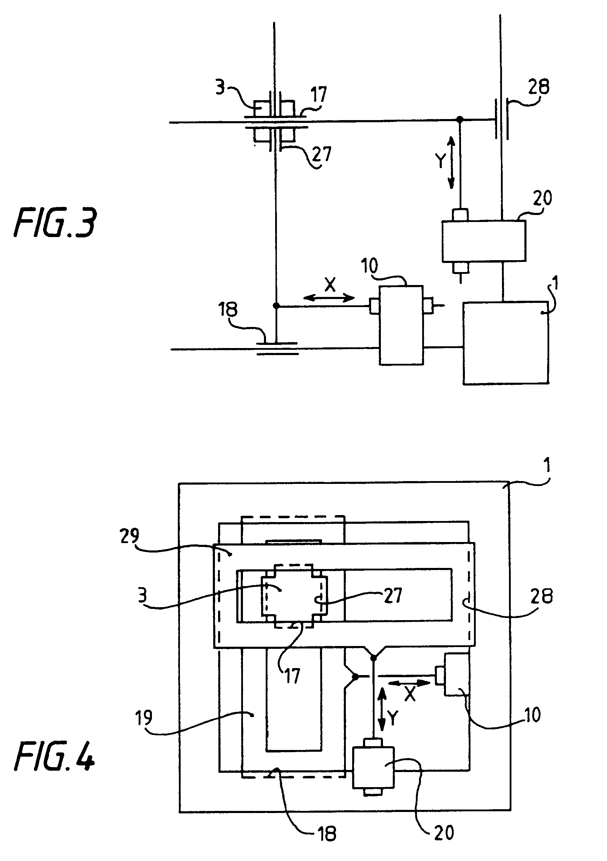

La figure 3 montre le schéma explicatif d'un dispositif à deux mouvements de translation perpendiculaire. Le dispositif comporte une plate-forme de référence 1, deux actionneurs 10 et 20 pour transmettre les mouvements de translation selon les axes x et y respectivement et une plate-forme mobile 3. Selon l'invention, les deux actionneurs sont solidaires de la plate-forme de référence et les deux chaînes cinématiques sont indépendantes l'une de l'autre. La première chaîne comprend l'actionneur 10, un premier moyen de guidage 18 et un deuxième moyen de guidage 27. La deuxième chaîne comprend l'actionneur 20, un premier moyen de guidage 28 et un deuxième moyen de guidage 17. Chaque chaîne se trouve ainsi relier la plate-fome de référence 1 d'une part et la plate-forme mobile 3 d'autre part. Un tel montage peut être qualifié de montage en parallèle par opposition au montage en série de la figure 2. On peut remarquer que les aryens de guidage 17 et 27 constituent également des aryens de découplage d'une chaîne par rapport à l'autre.

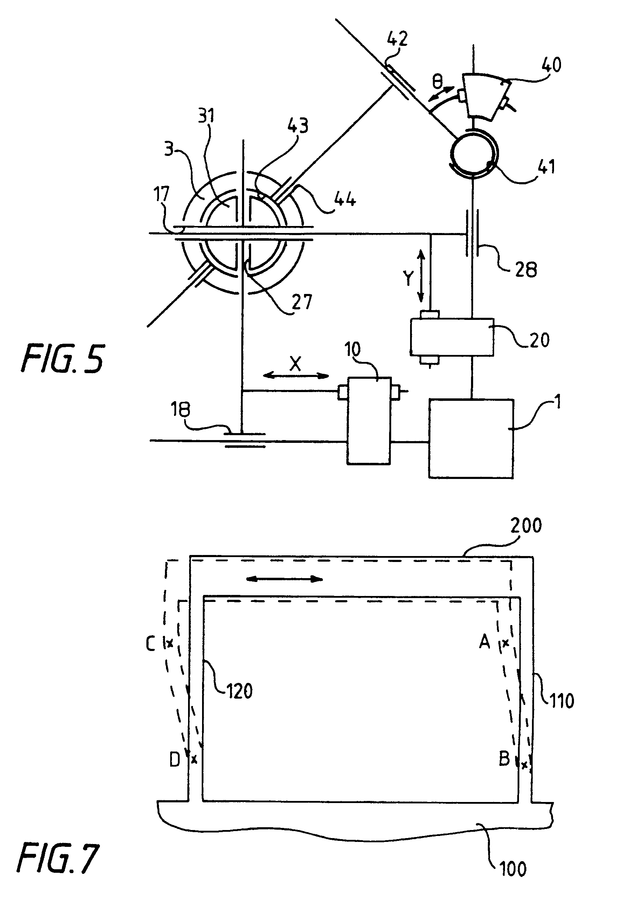

Un exemple de réalisation du schéma de la figure 3 est proposé à la figure 4. La plate-forme de référence 1 présente des surfaces d'appui deux à deux perpendiculaires (telles les surfaces 18 et 28) servant de guidages coulissants à deux plates-formes intermédiaires 19 et 29. Ces plates-formes sont commandées par deux actionneurs 10 et 20, solidaires de la plate-forme de référence 1, et comportent elles-mêmes des surfaces d'appui également deux à deux perpendiculaires (telles les surfaces 17 et 27) et servant de guidages coulissants à la plate-forme mobile 3.

La figure 5 montre un autre schéma explicatif d'un dispositif mais offrant trois degrés de liberté correspondant à deux translations et une rotation. On retrouve les deux chaînes en x et y, précédemment décrites, qui permettent de déplacer la plate-forme intermédiaire 31 selon les deux coordonnées rectangulaires. La chaîne correspondant au mouvement de rotation comprend l'actionneur 40, solidaire de la plate-forme de référence 1, et les moyens de guidage 41, 42 et 44,

La figure 6 montre un exemple d'un dispositif à trois degrés de liberté correspondant à trois translations selon trois directions perpendiculaires notées x, y et z. La base de référence 1 se présente sous la forme d'une trièdre rectangle dont chacune des trois faces présente des zones d'appui (18, 28 et 58). La première chaîne cinématique comprend l'actionneur 10 et les moyens de guidage 18, 27 et 57′. La deuxième chaîne comprend l'actionneur 20 et les moyens de guidage 28, 57 et 17′. La troisième chaîne comprend l'actionneur 50 et les moyens de guidage 58, 17 et 27′. La plate-forme mobile 3 est donc commandée en translation selon trois directions par trois chaînes indépendantes et reliées à la base de référence 1.

Bien que les principes soient, comme on l'a vu dans les exemples précédents, applicables avec les moyens de guidage coulissants, les performances de ces derniers sont limitées par la précision d'usinage des coulisses et les problèmes de jeu, de frottement et d'usure. L'utilisation de moyens de guidage élastiques permet de pallier à ces inconvénients. La figure 7 montre le principe d'un guidage élastique dans le cas d'un mouvement de translation. La plate-forme mobile 200 est rattachée à une base de référence 100 par deux lames élastiques minces et parallèles 110 et 120. La plate-forme mobile est capable d'un déplacement selon la direction de la flèche, lorsqu'elle est soumise à une action appropriée, grâce à la flexion des lames élastiques. Il est possible de définir deux axes de pivotement par lame, soit les axes notés A, B, C et D pour les lames 110 et 120. Dû aux mouvements de rotation autour des axes précédemment définis, le mouvement de la plate-forme mobile 200 n'est pas rigoureusement rectiligne.

La figure 8 montre un dispositif de translation par guidage élastique dans lequel les erreurs de déplacement dues à la rotation sont compensées. Le dispositif se présente sous la forme d'un double parallélogramme. La plate-forme mobile 200 est rattachée, par deux lames élastiques 110 et 120, à une plate-forme intermédiaire 300, laquelle est rattachée à une base de référence 100 par deux lames élastiques 130 et 140, parallèles aux deux premières. Un tel dispositif est décrit par exemple dans l'article précité de P.H. Sydenham.

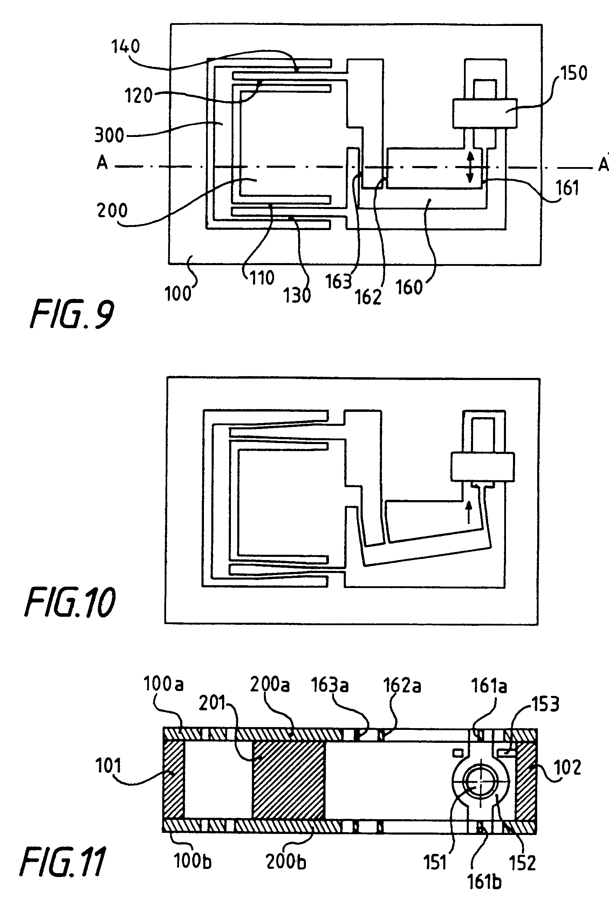

La figure 9 montre un exemple de réalisation du dispositif incorporant des moyens de commande. On reconnaît la structure, en double parallélogramme, formée par la plate-forme mobile 200, la plate-forme intermédiaire 300, les lames élastiques 110 à 140 et la base de référence 100. La commande de la plate-forme mobile 200 est assurée par un actionneur 150, fixé à la base de référence et un levier de transmission rigide 160 qui est relié à l'actionneur, à la base de référence et à la plate-forme mobile par trois lames élastiques 161, 162 et 163 respectivement. Cet arrangement pour la commande de la plate-forme mobile permet de réduire l'effet d'un manque de précision au niveau de l'actionneur (par exemple une vis micrométrique) grâce à la réduction opérée par le levier. Les lames élastiques 161 à 163 peuvent être d'inégales longueurs mais doivent avoir leurs centres alignés. Par ailleurs, dans le but d'assurer la linéarité du mouvement le levier 160, la condition suivante doit être remplie : $\dfrac{\ell_3 - \ell_2}{\ell_1 - \ell_2} = \dfrac{m}{n}$ ; où $\ell_1$, $\ell_2$ et $\ell_3$ sont les longueurs respectives des lames 161, 162 et 163, m est la distance entre les centres des lames 163 et 162 et n est la distance entre les centres des lames 161 et 162. La figure 10 montre le dispositif de la figure 9 dans une position déplacée.

Une solution avantageuse, tant du point de vie du coût de fabrication que du point de vue des performances, consiste à réaliser ces dispositifs sous forme monolithique. Tous les éléments de la chaîne sont taillés dans la même plaque, par exemple par électro-érosion dans une plaque en aluminium.

La figure 11 montre une vue en coupe d'un exemple de réalisation d'un dispositif à un degré de liberté dans lequel, pour accroître la rigidité des différentes pièces selon des directions autres que celle du mouvement désiré, deux plaques identiques à celle de la figure 9 ont été disposées en parallèle et réunies par des entretoises. La coupe, selon la direction AA′ de la figure 9, montre une plaque supérieure et une plaque inférieure réunies par trois entretoises 101, 102 et 201. Les deux entretoises 101 et 102 relient rigidement les deux bases de référence 100a et 100b, tandis que l'entretoise 201 relie rigidement entre elles les plates-formes mobiles 200a et 200b. La figure 11 montre également l'actionneur qui est constitué par une vis micrométrique 151 agissant sur un écrou baladeur 152, lequel est relié aux lames 161a et 161b.

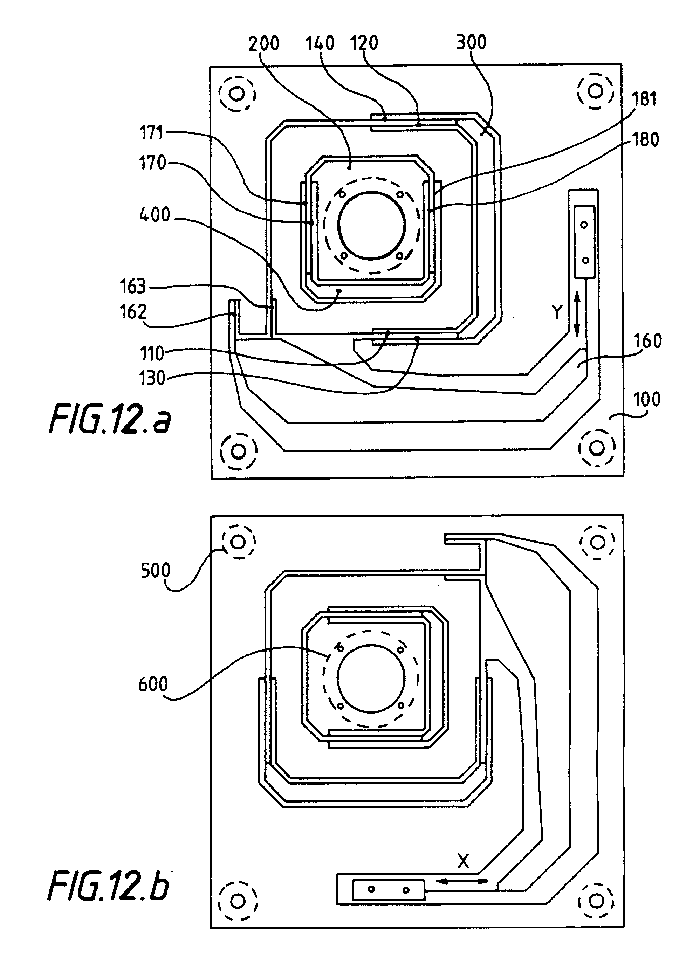

Cette disposition selon deux étages des structures élastiques planaires se prête particulièrement bien au cas des dispositifs de translation à deux degrés de liberté, par exemple selon deux directions perpendiculaires. La figure 12 montre un exemple de réalisation préféré de deux structures planaires permettant l'obtention de deux mouvements de translation selon deux directions perpendiculaires. Les deux structures de la figure 12.a et de la figure 12.b sont identiques et destinées à être disposées l'une sur l'autre de façon à permettre les mouvements selon les directions x et y. Sur chacune des structures on reconnaît la chaîne cinématique constituée par le levier de transmission 160, les lames minces 162 et 163, la plate-forme intermédiaire 300 et les lames élastiques 110 à 140. Des moyens de découplage entre les mouvements selon les directions x et y sont également prévus sous la forme d'une deuxième configuration en double parallélogramme. Cette deuxième configuration, comportant une deuxième plate-forme intermédiaire 400 et les lames élastiques 170, 171, 180 et 181, est perpendiculaire à la première et permet de découpler les deux chaînes cinématiques. La plate-forme mobile 200 est pourvue d'un trou central de façon à permettre le montage, par exemple, de composants optiques.

La figure 12.b montre encore l'emplacement d'entretoises 500 reliant entre elles les bases de référence des quatre structures planaires formant, comme indiqué précédemment, un montage compact à deux étages et l'emplacement de l'entretoise centrale reliant entre elles les plates-formes mobiles des quatre mêmes structures.

Bien que la présente invention ait été décrite dans le cadre d'exemples de réalisation particuliers, il est clair qu'elle est susceptible de modifications ou variantes sans sortir de son domaine tel que défini par les revendications.

**Revendications**

1. Dispositif de micropositionnement précis d'une plate-forme mobile par rapport à une base de référence selon deux directions comprenant, pour chacune des directions, une plaque et un actionneur (150) ; caractérisé en ce que :
   – chaque plaque comprend une base de référence (100), un levier de transmission (160), une première (300, 110, 120, 130,140) et une seconde (400, 170, 171, 180, 181) configuration en double parallélogramme et une plate-forme mobile ; chaque configuration en double parallélogramme comprenant, respectivement, une première (300) et une seconde (400) plate-forme intermédiaire, un premier (110, 120, 130, 140) et un second (170, 171, 180, 181) jeu de quatre lames élastiques parallèles ; et en ce que
   – lesdites bases de référence et lesdites plate-formes mobiles sont fixées rigidement entre elles;
   – ledit levier de transmission est connecté audit actionneur, à ladite base de référence et à ladite première configuration en double parallélogramme par l'intermédiaire de trois lames élastiques parallèles (161-163) pour permettre de transmettre, à la première configuration en double parallélogramme, le mouvement de translation de l'actionneur selon une première direction et avec un rapport de transmission donné ;
   – ladite première plate-forme intermédiaire est couplée d'une part à ladite base de référence et d'autre part à ladite seconde configuration en double parallélogramme par ledit premier jeu de quatre lames élastiques parallèles pour permettre le mouvement de translation, selon ladite première direction, transmis par le premier levier de transmission ; et
   – ladite seconde plate-forme intermédiaire est couplée d'une part à ladite première configuration en double parallélogramme et d'autre part à ladite plate-forme mobile par ledit second jeu de quatre lames élastiques parallèles, lesdites lames élastiques du second jeu et lesdites lames élastiques du premier jeu ayant des directions distinctes et étant disposées de manière à ce que ladite plate-forme mobile puisse être translatée dans une direction distincte à ladite première direction sans affecter ladite translation selon ladite première direction.

2. Dispositif selon la revendication 1, caractérisé en ce que les directions des mouvements de translation, transmis par lesdits actionneurs à la plate-forme mobile, soient perpendiculaires entre elles.

3. Dispositif de micropositionnement selon la revendication 1, caractérisé en ce que les centres des trois lames élastiques parallèles sont alignés.

4. Dispositif de micropositionnement selon la revendication 1, caractérisé en ce que les longueurs $\ell_1$, $\ell_2$ et $\ell_3$ des lames élastiques, reliant ledit levier respectivement à l'actionneur, la base de référence et à la première configuration en double parallélogramme, sont liées par la relation $\dfrac{\ell_3 - \ell_2}{\ell_1 - \ell_2} = \dfrac{n}{m}$ ; où m est la distance entre les centres des lames de longueurs $\ell_2$ et $\ell_3$ et n est la distance entre les centres des lames de longueurs $\ell_2$ et $\ell_1$.

5. Dispositif de micropositionnement selon la revendication 1, caractérisé en ce que les lames élastiques parallèles sont réalisées dans une plaque monolithique.

6. Dispositif de micropositionnement selon la revendication 5, caractérisé en ce que lesdites plaques monolithiques sont en aluminium et en ce que les lames élastiques parallèles sont réalisées par électro-érosion.

7. Dispositif de micropositionnement selon la revendication 2, caractérisé en ce qu'il comporte deux étages superposés et séparés par des entretoises, chaque étage étant formé de deux plaques.

8. Dispositif de micropositionnement selon la revendication 7, caractérisé en ce qu'il comporte en outre des moyens de commande des actionneurs et en ce que ces moyens de commande sont logés entre lesdits deux étages.

## Ansprüche

1. Vorrichtung für die präzise Mikropositionierung einer Plattform, die relativ zu einer Referenzbasis in zwei Richtungen beweglich ist, umfassend, für jede der Richtungen, eine Platte und einen Betätiger (150), dadurch gekennzeichnet, daß :

– jede Platte eine Referenzbasis (100), einen Übertragungshebel (160), eine erste (300, 110, 120, 130, 140) und eine zweite (400, 170, 171, 180, 181) Doppelparallelogrammkonfiguration und eine bewegliche Plattform umfaßt, wobei jede Doppelparallelogrammkonfiguration eine erste (300) bzw. eine zweite (400) Zwischenplattform, einen ersten (110, 120, 130, 140) bzw. einen zweiten (170, 171, 180, 181) Satz von vier parallelen elastischen Lamellen umfaßt und daß

– die Referenzbasen und die beweglichen Plattformen zwischeneinander starr festgelegt sind ;

– wobei der Übertragungshebel mit dem Betätiger verbunden ist, mit der Referenzbasis und mit der ersten Doppelparallelogrammkonfiguration über drei parallele elastische Lamellen (161-163) zum Ermöglichen der Übertragung, auf die erste Doppelparallelogrammkonfiguration, der Translationsbewegung des Betätigers in einer ersten Richtung und mit einem gegebenen Übertragungsverhältnis ;

– wobei die erste Zwischenplattform einerseits mit der Referenzbasis und andererseits mit der zweiten Doppelparallelogrammkonfiguration gekuppelt ist über den ersten Satz von vier parallelen elastischen Lamellen zum Ermöglichen der Translationsbewegung in der ersten Richtung, übertragen von dem ersten Übertragungshebel und

– wobei die zweite Zwischenplattform einerseits mit der ersten Doppelparallelogrammkonfiguration gekuppelt ist und andererseits mit der beweglichen Plattform über den zweiten Satz von parallelen elastischen Lamellen, welche elastische Lamellen des zweiten Satzes und elastische Lamellen des ersten Satzes unterschiedliche Richtungen aufweisen und derart angeordnet sind, daß die bewegliche Plattform translatorisch verlagerbar ist in einer Richtung unterschiedlich zu der ersten Richtung, ohne die Verlagerung in der Richtung zu beeinträchtigen.

2. Vorrichtung nach Anspruch 1, dadurch gekennzeichnet, daß die Translationsbewegungsrichtungen, übertragen von den Betätigern, auf die bewegliche Plattform zueinander senkrecht sind.

3. Vorrichtung für die Mikropositionierung nach Anspruch 1, dadurch gekennzeichnet, daß die Zentren der drei parallelen elastischen Lamellen ausgefluchtet sind.

4. Vorrichtung für die Mikropositionierung nach Anspruch 1, dadurch gekennzeichnet, daß die Längen $\ell_1$, $\ell_2$ und $\ell_3$ der elastischen Lamellen, welche den Hebel mit dem Betätiger, der Referenzbasis bzw. der ersten Doppelparallelogrammkonfiguration verbinden durch die Beziehung $\dfrac{\ell_3 - \ell_2}{\ell_1 - \ell_2} = \dfrac{n}{m}$ verknüpft sind, worin m der Abstand zwischen den Zentren der Lamellen der Längen und $\ell_3$ ist und n der Abstand zwischen den Zentren der Lamellen mit den Längen $\ell_2$ und $\ell_1$.

5. Vorrichtung für die Mikropositionierung nach Anspruch 1, dadurch gekennzeichnet, daß die parallelen elastischen Lamellen aus einer monolithischen Platte gefertigt sind.

6. Vorrichtung für die Mikropositionierung nach Anspruch 5, dadurch gekennzeichnet, daß die monolithischen Platten aus Aluminium bestehen und daß die parallelen elastischen Lamellen durch Elektroerosion hergestellt sind.

7. Vorrichtung für die Mikropositionierung nach Anspruch 2, dadurch gekennzeichnet, daß sie zwei einander überlagernde Etagen umfaßt, voneinander durch Pfosten getrennt, wobei jede Etage aus zwei Platten gebildet ist.

8. Vorrichtung für die Mikropositionierung nach Anspruch 7, dadurch gekennzeichnet, daß sie ferner Mittel zum Steuern der Betätiger aufweist und daß diese Steuermittel zwischen den beiden Etagen untergebracht sind.

## Claims

1. A device for precise miocropositioning of a mobile platform in relation to a reference base in two directions comprising, for each direction, a plate and an actuator (150) ; characterised in that :

– each plate comprises a reference base (100), transmission lever (160), a first (300, 110, 120, 130, 140) and a second (400, 170, 171, 180, 181) double parallelogram configuration and a mobile platform ; each double parallelogram configuration comprising, respectively, a first (300) and a second intermediate (400) platform, a first (100, 120, 130, 140) and a second (170, 171, 180, 181) set of four parallel elastic strips ; and in that
– the said reference bases and the said mobile platforms are rigidly fixed together ;
– the said transmission lever is connected to the said actuator, to the said reference base and to the said first double parallelogram by means of parallel elastic strips (161-163) to allow transmission, to the first double parallelogram configuration, of the translational movement of the actuator in a first direction and with a given transmission ratio ;
– the said first intermediate platform is coupled on the one hand to the said reference base and on the other to the said second double parallelogram configuration by the said first set of four parallel elastic strips to allow translational movement, in the said first direction, transmitted by the first transmission lever ; and
– the said second intermediate platform is coupled on the one hand to the said first double parallelogram configuration and on the other to the said mobile platform by the said second set of four parallel elastic strips, the said elastic strips of the second set and the elastic strips of the first set being differently directed and being disposed such that the said mobile platform can be translated in a direction distinct from the said first direction without affecting the said translation in the said first direction.

2. A micropositioning device according to claim 1, characterised in that the direction of translational movement, transmitted by the said actuators to the mobile platform, are perpendicular to each other.

3. A micropositioning device according to claim 1, characterised in that the centres of three elastic strips are aligned.

4. A micropositioning device according to claim 1, characterised in that the lenghts of 1, 2 and 3 of the elastic strips, joining the said lever to the actuator, the reference base and the first double parallelogramm configuration respectively are connected by the relationship $\frac{3-2}{1-2}=\frac{n}{m}$ ; where m is the distance between the centres of the strips of lenghts $l_2$ and $l_3$ and n is the distance between the centres of the strips of lengths $l_2$ and $l_1$.

5. A micropositioning device according to claim 1, characterised in that the parallel elastic strips are formed of a monolithic plate.

6. A micropositioning device according to claim 5, characterised in that the said monolithic plates are of aluminium and in that the parallel elastic strips are formed by electro-erosion.

7. A micropositioning device according to claim 2, characterised in that it comprises two superposed layers separated by braces, each layer being formed of two plates.

8. A micropositioning device according to claim 2, characterised in that it further comprises means for controlling the actuators and in that these control means are located between the said two layers.

FIG.1

FIG.2

*FIG.3*

*FIG.4*

FIG.5

FIG.7

10

FIG.6

FIG.8

FIG.9

FIG.10

FIG.11

FIG.12.a

FIG.12.b